# EUROPÄISCHE PATENTSCHRIFT

(11) **EP 0 530 448 B1**
(45) Veröffentlichungstag und Bekanntmachung des Hinweises auf die Patenterteilung: **20.04.1994**
(21) Anmeldenummer: 92109216.9
(22) Anmeldetag: 01.06.1992
(51) Int. Cl.: G01R 21/133

(54) **Verfahren zur Anzeige des Überschreitens der Anlaufschwelle eines statischen Elektrizitätszählers**
Method for displaying the crossing of the starting-threshold of a static electricity meter
Méthode pour l'affichage du franchissement du seuil de démarrage d'un compteur électrique statique

(30) Priorität: 07.08.1991 EP 91113278
(43) Veröffentlichungstag der Anmeldung: 10.03.1993
(73) Patentinhaber: SIEMENS AKTIENGESELLSCHAFT, 80333 München (DE)
(72) Erfinder: Windsheimer, Klaus, Dipl.-Ing., W-8533 Scheinfeld (DE)

(56) Entgegenhaltungen:
- EP-A- 0 240 102
- EP-A- 0 268 796
- DE-A- 3 033 095

## Beschreibung

### Siemens Aktiengesellschaft

Die Erfindung betrifft ein Verfahren zur Anzeige des Überschreitens einer Anlaufschwelle eines statischen Elektrizitätszählers, der eine Reihenschaltung einer Anpaßstufe, eines Multiplizierers, eines die zu messende elektrische Leistung in interne Impulse einer ersten Impulsfolge quantisierenden Quantisierers, einer Sperre, die nur solche internen Impulse der ersten Impulsfolge durchläßt, deren zeitlicher Abstand zum jeweils unmittelbar vorangehenden Impuls der ersten Impulsfolge unterhalb eines vorgegebenen Grenzwerts bleibt.

Derartige Verfahren sind in der Praxis bereits bekannt. Der prinzipielle Aufbau sowie die Funktion des hierbei verwendeten Zählers ist der europäischen Patentanmeldung EP-A-0 268 796 zu entnehmen. Durch die Anpaßstufe werden Strom und Spannung eines Verbrauchers auf eine für einen nachgeschalteten Multiplizierer geeignete Größe transformiert. Die leistungsproportionale Ausgangsspannung des Multiplizierers wird in einem Quantisierer in eine Impulsfolge mit leistungsproportionaler Frequenz umgewandelt. Je größer die Leistung ist, um so kürzer ist der zeitliche Abstand zwischen zwei aufeinanderfolgenden internen Impulsen dieser Impulsfolge. Elektrizitätszähler sollen gemäß den für sie geltenden Vorschriften nicht laufen, wenn der Verbraucherstrom Null oder sehr klein ist, d.h. das Zählen infolge einer unvermeidbaren Offsetspannung muß verhindert werden. Dies wird mittels einer Anlaufschwelle gemäß dem obengenannten Verfahren gewährleistet, nach deren Überschreiten der Zähler erst zu laufen beginnt. Der Anlaufschwelle entspricht hierbei ein bestimmter zeitlicher Abstand zwischen zwei internen Impulsen, der in der Praxis beispielsweise mehr als 30 Sekunden betragen kann.

Die beiden Zustände, d.h. das Über- und Unterschreiten der Anlaufschwelle werden im bekannten Verfahren durch eine optische Anzeige mittels der Leuchtdiode wiedergegeben.

Bei Grenzlast, d.h. maximalem Strom des Zählers, treten die am Ausgang des Quantisierers anstehenden internen Impulse mit verhältnismäßig hoher Frequenz auf, so daß eine direkte Ansteuerung der ersten Leuchtdiode durch die internen Impulse ein entsprechend hochfrequentes Aufleuchten zur Folge hätte, das vom menschlichen Auge als Dauerleuchten wahrgenommen würde. Um dies zu vermeiden, ist dem Quantisierer ein Teiler nachgeschaltet, der die Frequenz der ersten Impulsfolge mit internen Impulsen entsprechend seinem Teilerverhältnis in eine weniger hochfrequente zweite Impulsfolge mit Impulsen herunterteilt. Außerdem ist es möglich, daß Prüfstationen eine zu hohe Impulsfrequenz nicht erfassen und Impulse mit zu kurzer Pulsbreite als Störimpulse eliminieren. Durch jeweils einen Impuls der zweiten Impulsfolge am Ausgang des Teilers wird ein kurzzeitiges Aufleuchten konstanter Dauer ausgelöst, das bei Unterschreiten der Anlaufschwelle ausbleibt. Somit wird auch für den Grenzlastbetrieb des Zählers ein gut sichtbares und von einer Prüfstation auswertbares Blinken der Leuchtdiode erreicht.

Wird der Zähler nach seinem Einschalten nur wenig oberhalb der Anlaufschwelle belastet, so muß erst eine dem Teilerverhältnis entsprechende Anzahl von internen Impulsen der ersten Impulsfolge auftreten bis ein Impuls der zweiten Impulsfolge gebildet wird, durch den schließlich das kurzzeitige Aufleuchten der ersten Leuchtdiode ausgelöst wird. Da bei einem geringen Laststrom die internen Impulse der ersten Impulsfolge weit auseinander liegen (z.B. 30 Sekunden) ist die Dauer, bis ein Impuls der zweiten Impulsfolge kommt, sehr lang, nämlich ein dem Teilerverhältnis entsprechendes Vielfaches der Dauer zwischen zwei internen Impulsen der ersten Impulsfolge. Nach dem Einschalten des Zählers soll aber bereits möglichst frühzeitig angezeigt werden, ob eine Belastung oberhalb der Anlaufschwelle vorliegt, was einer Aufeinanderfolge von internen Impulsen der ersten Impulsfolge in entsprechend geringen zeitlichen Abständen entspricht.

In der DE-A- 30 33 095 ist ein Stromverbrauchszähler mit einem am Stromversorgungsnetz angeschlossenen induktiven Übertrager offenbart, der den zu messenden Laststrom in eine proportionale Wechselspannung umsetzt. Über eine nachfolgende Gleichrichterschaltung, in der die positive Halbwelle des Ausgangssignals des Übertragers verstärkt wird, wird das Signal einem spannungsgesteuerten Oszillator zugeführt. Dieser erzeugt an seinem Ausgang eine Pulsfrequenz, welche der Gleichspannung und damit dem Laststrom proportional ist. Die laststromabhängige Pulsfrequenz liegt am Eingang eines Frequenzteilers, der eine Leuchtdiode steuert. Diese leuchtet kontinuierlich, solange kein Laststrom fließt und blinkt bei eingeschalteter Last proportional zum Laststrom. Da die Leuchtdiode direkt von den Impulsen am Ausgang des Frequenzteilers angesteuert wird, erfolgt hier die Anzeige des Auftretens eines Laststromes zeitverzögert. Über das Verhalten des Stromverbrauchszählers nach seiner Zuschaltung an das Stromversorgungsnetz im Hinblick auf die Erfassung des Laststromzustands fehlen jegliche Angaben.

Der Erfindung liegt die Aufgabe zugrunde, ein Verfahren der obengenannten Art zu schaffen, bei dem nach Einschaltung des Zählers möglichst frühzeitig erkannt wird, ob die Anlaufschwelle überschritten ist. Die Aufgabe wird dadurch gelöst, daß sich der Sperre ein zur optischen Anzeige dienender Teiler mit einem ersten Ausgang anschließt, an dem aus den internen Impulsen der ersten Impulsfolge gemäß dem Teilerverhältnis heruntergeteilte Impulse erzeugt werden, durch die ein Aufleuchten einer ersten Leuchtdiode ausgelöst wird, wobei nach Einschalten des Zählers ein elektrisches Signal erzeugt wird, das die erste Leuchtdiode solange speist und zum Leuchten bringt, bis die internen Impulse am Ausgang der Sperre auftreten. Nach Einschalten des Zählers wird optisch angezeigt, wenn die Anlaufschwelle überschritten ist. Der Lastzustand wird nahezu unverzögert an eine Prüfstation zur Auswertung übermittelt. Eine besonders einfache Ausgestaltung des Verfahrens ist gegeben, wenn nach Einschalten des Zählers das Aufleuchten der ersten Leuchtdiode durch den ersten nach Einschalten des Zählers auftretenden internen Impuls am Ausgang der Sperre beendet wird. Es erweist sich als vorteilhaft, wenn als elektrisches Signal zum Einschalten der Leuchtdiode ein nach Einschalten des Zählers erzeugter Rücksetz-Impuls für einen Mikrocomputer oder einen Zähler-IC verwendet wird. Dieser Rücksetzimpuls wird nämlich zum Betrieb der internen Schaltung des Zählers ohnehin erzeugt. Darüber hinaus ist es mit den Verfahren nach Anspruch 4 und Anspruch 5 möglich, das Über- und Unterschreiten der Anlaufschwelle auch während des Lastbetriebs zu erfassen. Im Gegensatz zur Lösung mit dem Rücksetz-Impuls ist es hierbei nicht erforderlich, daß für den Quantisierer entsprechende Anfangsbedingungen geschaffen werden. Der weitere Vorteil der Anzeige für den Lastbetrieb gemäß den Ansprüchen 4 und 5 besteht darin, daß hiermit eventuelle Defekte z.B. am Strom- oder Spannungswandler oder am Netzteil zu erfassen sind. Ist z.B. aufgrund eines Defekts am Netzteil die Stromversorgung zum Überschreiten der Reset-Schwelle nicht ausreichend, so würde trotz eines über der Anlaufschwelle liegenden Laststromes keine entsprechende Anzeige erfolgen. Bei dem Verfahren nach Anspruch 4 ist es außerdem möglich mit Hilfe der den Energierichtungen zugeordneten Leuchtdioden den richtigen Anschluß für die Energierichtungen zu testen.

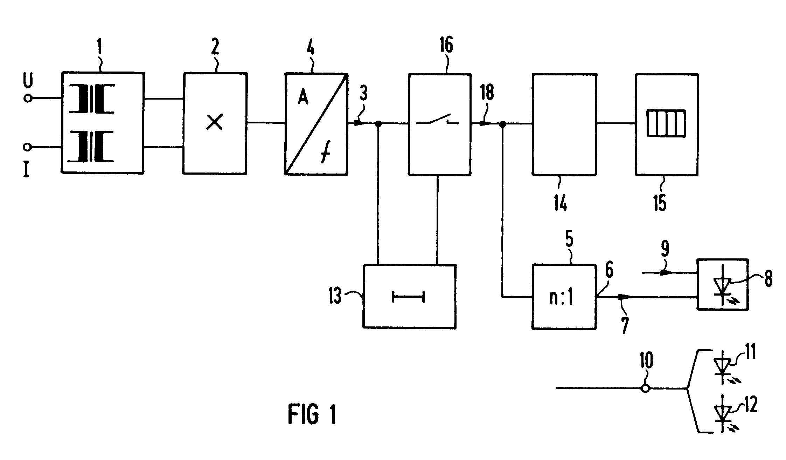

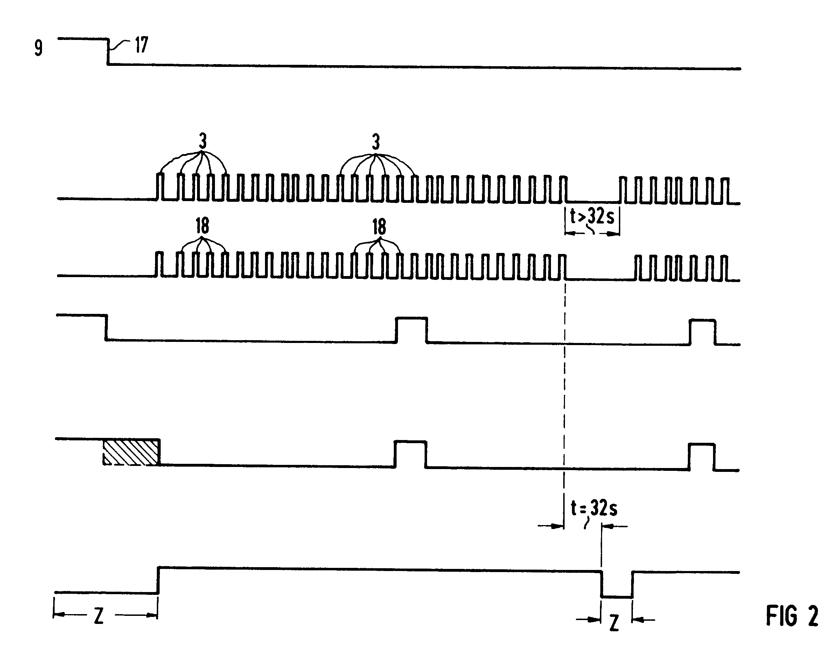

Ein Ausführungsbeispiel der Erfindung wird nachfolgend anhand der FIG 1 und 2 näher erläutert:
- FIG 1: zeigt den prinzipiellen Aufbau eines Ausführungsbeispiels für einen Zähler gemäß der Erfindung,
- FIG 2: im Ausführungsbeispiel ein Diagramm mit den Signalen zur optischen Anzeige des Lastzustands mittels Leuchtdioden.

Strom und Spannung eines Verbrauchers werden mit einer Anpaßstufe 1, die z.B. aus Meßwandlern bestehen kann, auf eine für einen nachgeschalteten Multiplizierer 2 geeignete Größe transformiert. Die leistungsproportionale Ausgangsspannung des Multiplizierers 2 wird in einem Quantisierer 4 in eine Impulsfolge mit leistungsproportionaler Frequenz umgewandelt. Die Impulsfolge besteht aus sogenannten internen Impulsen 3 einer ersten Impulsfolge. Dem Quantisierer 4 ist eine elektronische Sperre 16 nachgeschaltet. In einer Pulsabstandskontrolle 13 wird das Ausgangssignal des Quantisierers 4 hinsichtlich des Impulsabstandes zwischen zwei aufeinanderfolgenden internen Impulsen 3 überprüft.

Jeder interne Impuls 3 startet die Impulsabstandskontrolle 13. Überschreitet der zeitliche Abstand zwischen einem ersten und einem unmittelbar nachfolgenden zweiten internen Impuls 3 eine vorgegebene Dauer, so wird ein die Sperre 16 aktivierendes Sperrsignal erzeugt und dadurch der zweite Impuls 3 nicht zum Frequenzteiler 14 weitergeleitet. Durch den zweiten internen Impuls 3 wird die Impulsabstandkontrolle 13 neu gestartet und das Sperrsignal aufgehoben. Liegt der zeitliche Abstand zwischen dem zweiten und einem unmittelbar nachfolgenden dritten internen Impuls 3 innerhalb der vorgegebenen Dauer, so wird dieser über die Sperre 16 dem Frequenzteiler 14 zugeführt und dort aufsummiert. Am Ausgang der Sperre 16 liegen nur solche internen Impulse 18 der ersten Impulsfolge, deren zeitlicher Abstand zum direkt vorangehenden Impuls 3 der ersten Impulsfolge unterhalb eines vorgegebenen Grenzwertes liegen, der z.B. die Anlaufschwelle des Elektrizitätszählers darstellt. Überschreitet die Anzahl der im Frequenzteiler 14 aufsummierten internen Impulse 18 einen vorgegebenen Wert, so wird ein Impuls an die Anzeige 15 weitergeleitet, der z.B. ein Zählwerk weiterschaltet. Zwischen die Sperre 16 und den Frequenzteiler 14 ist ein weiterer Teiler 5 geschaltet, dessen heruntergesetzte Impulse 7 am Ausgang 6 das Aufleuchten einer nachgeschalteten Leuchtdiode 8 für konstante Dauer auslöst. Dabei ist das Teilerverhältnis des Teilers 5 so gewählt, daß sich bei Grenzlast des Zählers ein für das Auge gut sichtbares Blinken der Leuchtdiode 8 ergibt. Die Blinkfrequenz beträgt beispielsweise 10 Hz.

In FIG 2 ist ein Diagramm mit den Signalen und deren zeitliche Zuordnung dargestellt, die das Überschreiten einer Anlaufschwelle erfindungsgemäß durch Leuchtdioden anzeigen. In der ersten Spur von oben ist ein Rücksetz-Impuls 9 dargestellt, der im Einschaltzeitpunkt 17 des Zählers vom High- auf den Low-Pegel wechselt. Die zweite Spur zeigt interne Impulse 3 am Ausgang des Quantisierers 4. Die von der Sperre 16 durchgelassenen internen Impulse 18 sind in der Spur 3 dargestellt.

Aus der Spur 4 ist die optische Anzeige nach dem bisher bekannten Verfahren durch die Leuchtdiode 8 ersichtlich. Ab dem Einschaltzeitpunkt 17 gemäß Spur 1 ist die Leuchtdiode 8 im ausgeschalteten Zustand solange bis die durch das Teilerverhältnis des Teilers 5 gegebene Anzahl von internen Impulsen 3 aufgetreten ist. Erst dann wird die Leuchtdiode 8 für eine konstante Dauer eingeschaltet. Erfindungsgemäß wird der Rücksetz-Impuls 9 mit dem Pegelwechsel zum Einschaltzeitpunkt dazu verwendet, die Leuchtdiode 8 nach dem Einschaltzeitpunkt 17 solange zu speisen und zum Leuchten zu bringen bis interne Impulse 18 auftreten, was in der fünften Spur von oben dargestellt ist. Die Benutzung des ersten internen Impulses 18 stellt eine besonders einfache und damit vorteilhafte Ausführungsform dar, jedoch kann beispielsweise ebenfalls auch der zweite oder n-te interne Impuls 18 verwendet werden. Das erfindungsgemäße Verfahren zeichnet sich durch die nach Einschalten baldigst mögliche Anzeige des Betriebszustands aus. Im statischen Elektrizitätszähler werden üblicherweise Mikrocomputer oder Zähler-IC eingesetzt, zu deren Betrieb beim Einschalten des Zählers ohnehin der Rücksetz-Impuls 9 zur Verfügung gestellt werden muß. Somit ist also dieses ohnehin vorhandene Signal für das erfindungsgemäße Verfahren verwendbar.

Zweienergierichtungszähler haben gemäß FIG 1 einen weiteren Ausgang 10, an den eine zweite 11 und eine dritte Leuchtdiode 12 zur Anzeige der jeweils vorhandenen Energierichtung anschließbar ist. Der Ausgang 10 wird in den hochohmigen Zustand Z geschaltet, sofern der zeitliche Abstand zwischen zwei internen Impulsen 3 die bereits erwähnte Zeitschwelle überschreitet, was einem Unterschreiten einer bestimmten Anlaufschwelle entspricht. Der Wechsel des Ausgangs 10 in den hochohmigen Zustand ist in FIG 2 durch die unterste Spur dargestellt. Zwischen den hochohmigen Zuständen Z ist der Ausgang 10 auf High- oder Low-Pegel je nach Energierichtung.

Für einen Einenergierichtungszähler kann ebenfalls der zweite Ausgang 10 vorgesehen sein, an dem in diesem Fall nur die zweite Leuchtdiode 11 angeschlossen wird. Ergibt eine schaltungsinterne Prüfung der Dauer zwischen zwei internen Impulsen 3, daß die Anlaufschwelle nicht überschritten ist, so wird dies durch Abschalten dieser Leuchtdiode 11 optisch angezeigt.

Nach dem erfindungsgemäßen Verfahren ist somit ohne zusätzlichen Aufwand eine einfache Anzeige der Lastzustände möglich.

## Patentansprüche

1. Verfahren zur Anzeige des Überschreitens einer Anlaufschwelle eines statischen Elektrizitätszählers, der eine Reihenschaltung einer Anpaßstufe (1), eines Multiplizierers (2), eines die zu messende elektrische Leistung in interne Impulse (3) einer ersten Impulsfolge quantisierenden Quantisierers (4), einer Sperre (16), die nur solche internen Impulse (18) der ersten Impulsfolge durchläßt, deren zeitlicher Abstand zum jeweils unmittelbar vorangehenden Impuls (3) der ersten Impulsfolge unterhalb eines vorgegebenen Grenzwerts bleibt,
**dadurch gekennzeichnet**,
daß sich der Sperre (16) ein zur optischen Anzeige dienender Teiler (5) mit einem ersten Ausgang (6) anschließt, an dem aus den internen Impulsen (18) gemäß dem Teilerverhältnis heruntergeteilte Impulse (7) erzeugt werden, durch die ein Aufleuchten einer ersten Leuchtdiode (8) ausgelöst wird, wobei nach Einschalten des Zählers ein elektrisches Signal (9) erzeugt wird, das die erste Leuchtdiode (8) solange speist und zum Leuchten bringt, bis die internen Impulse (18) am Ausgang der Sperre (16) auftreten.

2. Verfahren nach Anspruch 1, **dadurch gekennzeichnet,** daß nach Einschalten des Zählers das Aufleuchten der ersten Leuchtdiode (8) durch den ersten nach Einschalten des Zählers auftretenden internen Impuls (18) am Ausgang der Sperre beendet wird.

3. Verfahren nach Anspruch 1 oder 2, **dadurch** **gekennzeichnet**, daß als elektrisches Signal ein nach Einschalten des Zählers gesetzter Rücksetz-Impuls (9) für einen Mikrocomputer oder einen Zähler-IC verwendet wird.

4. Verfahren nach einem der vorangehenden Ansprüchen 1-3, **dadurch gekennzeichnet,** daß der Zähler ein Zweienergierichtungszähler ist, an dem ein zweiter Ausgang (10) zum Anschluß einer zweiten Leuchtdiode (11) und einer dritten Leuchtdiode (12) vorgesehen ist, daß abhängig von der Energierichtung die zweite (11) oder dritte Leuchtdiode (12) leuchtet, und daß der zweite Ausgang (10) für die Dauer, in der die Anlaufschwelle nicht überschritten ist, im hochohmigen Zustand gehalten ist.

5. Verfahren nach einem der vorangehenden Ansprüche 1-3, **dadurch gekennzeichnet,** daß der Zähler zur Messung in einer Energierichtung dient, und daß ein zweiter Ausgang (10) zum Anschluß einer zweiten Leuchtdiode (11) vorgesehen ist, die nur dann aufleuchtet, wenn die Anlaufschwelle für die jeweilige Energierichtung überschritten ist.

6. Verfahren nach einem der vorangehenden Ansprüche, **dadurch gekennzeichnet,** daß der vorgegebene Grenzwert der Anlaufschwelle entspricht.

## Claims

1. A method for indicating when a start-up threshold of a solid-state electricity meter has been exceeded, which (has) a series connection of an adaptor stage (1), a multiplier (2), a quantiser (4) quantising the electrical energy to be measured in internal pulses (3) of a first pulse train, a latch (16), which only allows through such internal pulses (18) of the first pulse train, the interval of which, relative to the directly preceding respective pulse (3) of the first pulse train, remains below a predetermined limiting value, characterised in that the latch (16) connects a divider (5) serving for optical display to a first output (6), at which pulses (7) are generated from the internal pulses (18) divided down according to the divider ratio, through which an illumination of a first light-emitting diode (8) is triggered, wherein after connecting the meter an electrical signal (9) is triggered, which feeds the first light-emitting diode (8) and illuminates this until the internal pulses (18) occur at the output of the latch (16).

2. A method according to claim 1, characterised in that after connecting the meter the illumination of the first light-emitting diode (8) is terminated by the first internal pulse (18), occurring after the connection of the meter, at the output of the latch.

3. A method according to claim 1 or 2, characterised in that a reset pulse (9) for a microcomputer or a meter-IC, set once the meter is connected, is used as an electrical signal.

4. A method according to one of the preceding claims 1 to 3, characterised in that the meter is a double-way meter, at which a second output (10) for connecting a second light-emitting diode (11) and a third light-emitting diode (12) is provided, that dependent on the direction of power flow, the second (11) or third light-emitting diode (12) illuminates and that the second output (10) is maintained in a high-resistant state for the period in which the start-up threshold is not exceeded.

5. A method according to one of the preceding claims 1 to 3, characterised in that the meter serves to measure in one direction of power flow, and in that a second output (10) for connecting a second light-emitting diode (11) is provided, which only lights up when the start-up threshold for the respective direction of power flow has been exceeded.

6. A method according to one of the preceding claims, characterised in that the predetermined limiting value corresponds to the start-up threshold.

## Revendications

1. Procédé d'affichage du dépassement d'un seuil de démarrage d'un compteur d'électricité statique, qui comporte un montage série comportant un étage d'adaptation (1), un multiplicateur (2), un quantificateur (4) qui quantifie la puissance électrique à mesurer en des impulsions internes (3) d'une première suite d'impulsions, un dispositif de blocage (16), qui ne transmet que des impulsions internes (18) de la première suite d'impulsions, dont l'intervalle de temps par rapport à l'impulsion (3) respectivement immédiatement précédente, de la première suite d'impulsions reste inférieur à une valeur limite prédéterminée,
caractérisé par le fait
que le dispositif de blocage (16) raccorde un diviseur (5) utilisé pour l'affichage optique, à une première sortie (6), sur laquelle sont produites des impulsions (7) qui sont formées par division, conformément au rapport de division, à partir des impulsions internes (18) et au moyen desquelles un éclairement d'une première diode à luminescence (8) est déclenché, auquel cas, après le démarrage du compteur, un signal électrique (9) est produit, qui alimente la première diode à luminescence (8) et l'amène à éclairer, jusqu'à ce que les impulsions internes (18) sortent au niveau de la sortie du dispositif de blocage (16).

2. Procédé suivant la revendication 1, caractérisé par le fait qu'après le démarrage du compteur, l'éclairement de la première diode à luminescence (8) est interrompu par la première impulsion interne (18), qui apparaît après le démarrage du compteur, à la sortie du dispositif de blocage.

3. Procédé suivant la revendication 1 ou 2, caractérisé par le fait qu'on utilise comme signal électrique une impulsion de remise à l'état initial (9), qui est positionnée après le démarrage du compteur, pour un micro-ordinateur ou un circuit intégré du compteur.

4. Procédé suivant l'une des revendications précédentes 1-3, caractérisé par le fait que le compteur est un compteur comptant dans deux sens de circulation de l'énergie, sur lequel il est prévu une seconde sortie (10) pour le raccordement d'une seconde diode à luminescence (11) et d'une troisième diode à luminescence (12), que la seconde diode à luminescence (11) ou la troisième diode à luminescence (12) éclaire en fonction du sens de circulation de l''énergie et que la seconde sortie (10) est maintenue dans l'état de forte valeur ohmique, pendant la durée pendant laquelle le seuil de démarrage n'est pas dépassé.

5. Procédé suivant la revendication 1-3, caractérisé par le fait que le compteur est utilisé pour la mesure dans un sens de circulation de l'énergie, et qu'il est prévu une seconde sortie (17) pour le raccordement d'une seconde diode à luminescence (11), qui éclaire uniquement lorsque le seuil de démarrage est dépassé pour le sens respectif de circulation de l'énergie.

6. Procédé suivant l'une des revendications précédentes, caractérisé par le fait que la valeur limite prédéterminée correspond au seuil de démarrage.
